# FASCICULE DE BREVET EUROPEEN

(11) **EP 1 630 961 B1**
(45) Date de publication et mention de la délivrance du brevet: **18.11.2009**
(21) Numéro de dépôt: 05106595.1
(22) Date de dépôt: 19.07.2005
(51) Int. Cl.: H03K 17/082

(54) **Dispositif de commande d'un transistor de puissance**
Treiberschaltung für einen Leistungstransistor
Power transistor control device

(30) Priorité: 27.08.2004 FR 0409129
(43) Date de publication de la demande: 01.03.2006
(73) Titulaire: Schneider Toshiba Inverter Europe SAS, 27120 Pacy sur Eure (FR)
(72) Inventeur: Grbovic, Petar, Schneider Toshiba Inverter Eur.SAS, 27120 Pacy sur Eure (FR)
(74) Mandataire: Dufresne, Thierry

(56) Documents cités:
- EP-A- 0 913 919
- US-A1- 2002 131 276
- ECKEL H-G ET AL: "Optimization of the turn-off performance of IGBT at overcurrent and short-circuit current" THE EUROPEAN POWER ELECTRONICS ASSOCAITION, 1993, pages 317-322, XP006511564

## Description

La présente invention se rapporte à un dispositif de commande de composants semiconducteurs électroniques de puissance, de type IGBT (Insulated Gate Bipolar Transistor - transistor bipolaire à grille isolée) ou MOSFET (Metal Oxide Silicon Field Effect Transistor), visant notamment à améliorer le processus d'extinction des composants, en particulier dans le cadre d'une utilisation dans un onduleur à modulation de largeur d'impulsion (MLI), ou Pulse Width Modulation (PWM).

Les onduleurs MLI se rencontrent fréquemment dans des applications telles que des alimentations secourues ou des variateurs de vitesse, du type convertisseur de fréquence, pour moteurs électriques asynchrones. Dans un convertisseur de fréquence triphasé, un redresseur fournit une source de tension de bus continu, par exemple de 250-400V ou 500-800V, à partir d'un réseau triphasé. Un onduleur produit ensuite, à partir de ce bus continu, une tension d'amplitude et de fréquence variables permettant de commander le moteur. De façon connue, un tel onduleur peut comporter six composants IGBT de forte puissance chacun en parallèle avec une diode de roue libre (Free Wheeling Diode FWD). Par exemple, pour une source de bus continu d'une valeur de respectivement 250-400V ou 500-800V, des IGBT avec une tension de Collecteur de respectivement 600V ou 1200V peuvent être utilisés.

Un IGBT est un composant de puissance bien connu se comportant de manière simplifiée comme une association en cascade d'un transistor à effet de champ (MOSFET) et d'un transistor de jonction bipolaire (BJT). En entrée, un IGBT est commandé en tension par une électrode de grille comme un MOSFET, mais les caractéristiques du courant de sortie sont proches de celle d'un transistor bipolaire BJT. La tenue en court-circuit représente un des avantages appréciables de l'IGBT. La valeur de la tension Grille-Emetteur, appelée parfois tension de grille, est généralement de l'ordre de 15 à 17V à l'état ON pour diminuer les pertes de conduction. La valeur de la tension de grille à l'état OFF dépend de différents facteurs : tension de bus continu, capacité Grille-Emetteur, pente souhaitable de tension de Collecteur. Elle est généralement de l'ordre de 0 à -15V pour éviter un allumage parasite du dispositif opposé quand le transistor commute.

Pendant l'extinction d'un IGBT (c'est-à-dire passage de l'état ON conducteur à l'état OFF non-conducteur), de fortes surtensions entre Collecteur et Emetteur peuvent être générées par les brusques variations du courant à travers des inductances parasites dans l'IGBT. Ces surtensions sont directement proportionnelles à la vitesse de changement du courant de collecteur d'IGBT (vitesse de commutation). Avec de forts courants, la vitesse de commutation est augmentée causant ainsi des surtensions à l'extinction considérablement élevées. C'est en particulier le cas durant un court-circuit quand le courant de commutation peut atteindre 6 à 8 fois le courant nominal, les surtensions ainsi induites pouvant alors provoquer la destruction de l'IGBT.

Pendant sa phase d'extinction, un IGBT ne fonctionne pas dans sa zone de fonctionnement linéaire et la pente du courant de Collecteur ne peut pas être contrôlée. La pente du courant de Collecteur pourrait être contrôlée indépendamment si une résistance de grille élevée était employée. Cependant, dans ce cas les pertes de puissance d'extinction et la durée d'extinction totale augmenteraient. L'augmentation de la durée d'extinction exigerait alors de rallonger le temps mort programmé, ce qui pourrait notamment causer un problème d'oscillation du courant moteur et du couple, particulièrement à vitesse réduite.

Avec les commandes conventionnelles, il n'est pas possible de contrôler efficacement la vitesse d'extinction sans encourir de fortes pertes d'extinction, en particulier pour les modules IGBT de 600V qui ont des tensions opérationnelles maximales supérieures à 400V. Afin d'empêcher la destruction d'IGBTs lors d'une surtension, les circuits standards de commande de grille activent une extinction lente (appelée protection de désaturation) quand un court-circuit est détecté. Cependant le problème est que l'extinction d'un IGBT rapide peut démarrer avant que l'extinction lente ne soit activée par la protection de désaturation. Dans ce cas la capacité de grille d'IGBT est rapidement déchargée, ce qui cause un changement rapide du courant de collecteur et en conséquence des surtensions élevées d'extinction.

Dans ce cas, il est connu d'utiliser des condensateurs d'écrêtage, ou écrêteurs. Néanmoins, cette solution est chère et encombrante, n'est que partiellement efficace pour limiter les surtensions et peut créer des résonances indésirables.

D'autres solutions ont également été proposées. Dans ces différentes solutions, il est nécessaire de détecter une information sur l'état de l'IGBT et, en réponse à cette information, de mettre en place une action sur le circuit de commande de grille de l'IGBT (feedback action). Par exemple, le document US5,926,012 propose un circuit actif de commande de grille basé sur l'inductance de fuite entre l'émetteur puissance et l'émetteur auxiliaire de l'IGBT et sur la détection de di/dt. Le document US6,208,185 propose un circuit actif de commande de grille basé sur un circuit à trois étages pour la commande de di/dt et dv/dt. Le document US6,459,324 propose un circuit actif de commande de grille basé sur un retour de la tension Grille-Emetteur pour commander la résistance de grille durant les processus d'extinction et d'amorçage de l'IGBT.

Le principal problème des méthodes basées sur un retour d'information de l'état de l'IGBT est que, avec les nouvelles générations de composants en particulier les IGBTs basse tension à commutation rapide, le temps dont dispose le circuit de protection pour réagir est très court et ces méthodes peuvent s'avérer trop lentes en particulier lors d'un court-circuit de bras de pont (arm short circuit) ou lors d'un autre court-circuit quand l'IGBT travaille dans sa zone active. Il n'est alors pas certain d'éteindre de façon sûre un courant de court-circuit avec une tension de bus opérationnelle maximale.

C'est pourquoi, la présente invention décrit un dispositif de commande de grille qui comprend une information de retour (feed-back) ainsi qu'une rétroaction dynamique (feed-forward ou action anticipatrice) de la tension de grille du composant de puissance, tel qu'un IGBT, de façon à contrôler efficacement la surtension Collecteur-Emetteur V_{CE} lors de la phase d'extinction. L'invention permet de contrôler simplement et efficacement la pente du courant d'extinction dans toutes les conditions opérationnelles.

La surtension créée par l'inductance parasite du bus continu et l'inductance interne de l'IGBT durant l'extinction de l'IGBT est contrôlée. Ceci permet d'éliminer le besoin de condensateurs d'écrêtage HF chers et encombrants et une structure de bus continu de faible inductance n'est pas exigée. La commande de grille proposée peut efficacement contrôler la surtension dans toutes les conditions d'utilisation régulières, y compris lors de surcharge et court-circuit sous une tension de bus maximale, typiquement durant un freinage dynamique.

Les pertes liées à la commutation et la durée de commutation totale aux conditions nominales ne sont pas augmentées. Les pertes de commutation avec la commande de grille proposée dans l'invention peuvent être inférieures aux pertes de commutation avec une commande conventionnelle de grille, en fonction de la technologie d'IGBT (NPT, SPT, TRENCH).

Pour cela, l'invention décrit un dispositif de commande de grille d'un composant semi-conducteur de puissance de type IGBT, comprenant un circuit d'entrée fournissant en sortie une tension de grille de référence à partir d'un ordre de commande du composant IGBT, un étage d'amplification en courant de ladite tension de référence pour délivrer un courant de grille du composant IGBT, cet étage d'amplification comprenant un circuit d'amorçage et un circuit d'extinction rapide, un circuit d'extinction lente connecté entre la grille du composant IGBT et la sortie du circuit d'entrée, un circuit de détection d'une tension Collecteur-Emetteur du composant IGBT. Le circuit d'entrée est un circuit générateur de rampe et le dispositif comporte un circuit de retour connecté en sortie du circuit de détection et fournissant un signal de retour agissant sur le circuit d'extinction rapide et sur la sortie du circuit générateur.

Selon une caractéristique, le circuit générateur de rampe fournit une tension de référence avec une rampe de montée suite à un ordre de commande d'allumage du composant IGBT et avec une rampe de descente différente de la rampe de montée suite à un ordre de commande d'extinction du composant IGBT.

Selon une autre caractéristique, lors d'une phase d'extinction du composant IGBT, le circuit de détection détecte un dépassement de seuil de la tension Collecteur-Emetteur du composant IGBT et un dépassement de seuil de variation de la tension Collecteur-Emetteur du composant IGBT.

Selon une autre caractéristique, le circuit d'extinction rapide comporte un transistor bipolaire principal dont la base est pilotée par la sortie du circuit générateur et par le signal de retour, et dont l'émetteur est relié à la grille du composant IGBT via une résistance d'extinction. Le circuit d'extinction lente comporte une résistance de décharge qui est supérieure à la résistance d'extinction.

Selon une autre caractéristique, le circuit de retour comporte un transistor bipolaire auxiliaire dont la base est reliée à une première sortie du circuit de détection, dont le collecteur est relié à une tension d'alimentation positive et dont l'émetteur est relié au signal de retour, de façon à maintenir le signal de retour durant un temps de maintien déterminé. Une seconde sortie du circuit de détection est directement reliée au signal de retour.

L'invention décrit également un appareil de commande d'un moteur électrique comprenant deux composants de puissance de type IGBT pour chaque phase dudit moteur, chaque composant de puissance de l'appareil étant commandé par un tel dispositif de commande.

L'invention décrit enfin une méthode de commande pour l'extinction d'un composant semi-conducteur de puissance de type IGBT, comportant trois étapes. Durant une première étape, la capacité Grille-Emetteur du composant IGBT se décharge principalement à travers une résistance d'extinction d'un circuit d'extinction rapide. Durant une deuxième étape, un circuit de retour connecté en sortie un circuit de détection d'une tension Collecteur-Emetteur du composant IGBT fournit un signal de retour agissant sur le circuit d'extinction rapide, de sorte que la capacité Grille-Emetteur se décharge durant un temps de maintien uniquement à travers une résistance de décharge supérieure à la résistance d'extinction. Durant une troisième étape, la capacité Grille-Emetteur se décharge principalement à travers la résistance d'extinction.

D'autres caractéristiques et avantages vont apparaître dans la description détaillée qui suit en se référant à un mode de réalisation donné à titre d'exemple et représenté par les dessins annexés sur lesquels :
- la figure 1 représente le principe général simplifié d'un mode de réalisation du dispositif de commande conforme à l'invention,
- la figure 2 détaille un exemple de schéma du circuit générateur de rampe,
- la figure 3 détaille un exemple de schéma du circuit d'extinction rapide et du circuit d'extinction lente,
- la figure 4 détaille un exemple de schéma du circuit de détection et du circuit de retour,
- la figure 5 détaille un exemple de schéma du circuit d'amorçage,
- la figure 6 montre l'utilisation du dispositif de commande décrit dans l'invention pour la commande d'un moteur triphasé.

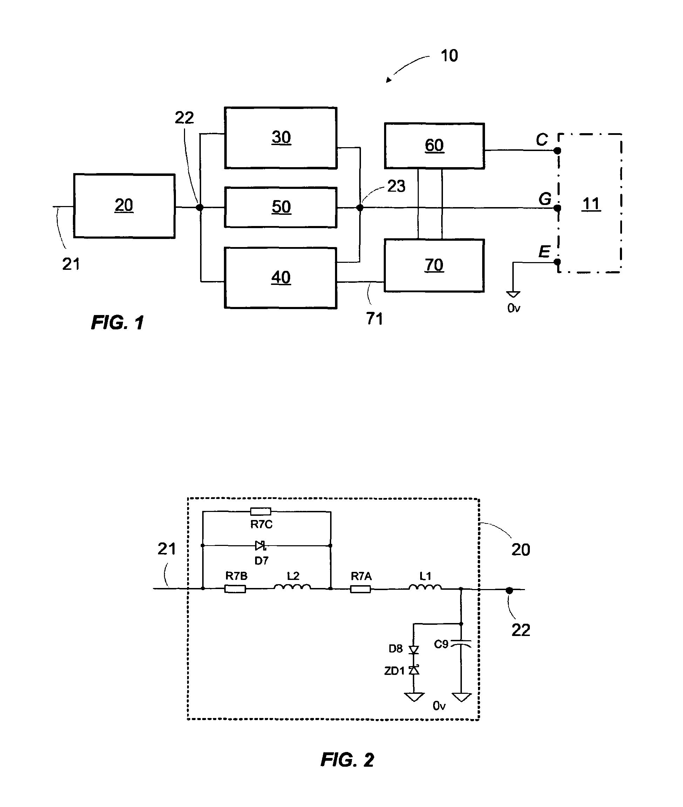

En référence à la figure 1, un composant semi-conducteur de puissance 11, de type transistor IGBT, comprend une grille G (ou GATE), un collecteur C (ou COLLECTOR) et un émetteur E (ou EMETTOR). Un dispositif de commande 10 de grille de l'IGBT 11 est chargé de fournir un courant de commande sur la grille G à partir d'un signal, ou ordre de commande, arrivant sur une entrée 21 et provenant par exemple d'une unité de traitement amont. Dans le mode de réalisation présenté, la tension de l'entrée 21 prend environ une valeur +16V, appelée tension d'alimentation positive V_{cc}, pour commander l'état ON de l'IGBT 11 et une valeur -10V, appelée tension d'alimentation négative V_{EE}, pour commander l'état OFF de l'IGBT 11.

Le dispositif de commande 10 comporte un circuit générateur de rampe 20, un étage d'amplification de courant composé d'un circuit d'amorçage 30 et d'un circuit d'extinction rapide 40, un circuit d'extinction lente 50, un circuit de détection 60 d'une tension Collecteur-Emetteur V_{CE} et un circuit de retour 70 agissant sur le circuit d'extinction rapide 40.

En référence au schéma électrique de la figure 2, le circuit générateur de rampe 20 reçoit un ordre de commande sur l'entrée 21 et fournit en sortie une tension de grille de référence sur un noeud 22. Ce circuit générateur de rampe 20 comprend des résistances R7A, R7B et R7C, une capacité C9 ainsi que des inductances L1, L2 qui permettent de créer une rampe de montée pour la tension de référence à la suite d'un ordre d'allumage du composant 11 (passage de l'état OFF à l'état ON, c'est-à-dire front montant de l'entrée 21), ainsi qu'une rampe de descente pour la tension de référence à la suite d'un ordre d'extinction du composant 11 (passage de l'état ON à l'état OFF, c'est-à-dire front descendant de l'entrée 21). Ces rampes permettent de maîtriser les variations de la tension de référence et donc de maîtriser les variations du courant de collecteur de l'IGBT.

Préférentiellement, la rampe de montée lors de l'allumage du composant 11 est différente de la rampe de descente lors de l'extinction du composant 11, ce qui donne plus de souplesse dans la mise au point du dispositif de commande. Pour cela, le circuit générateur 20 comporte par exemple une diode D7 en parallèle avec R7B, R7C et L2. Lors du front montant de l'entrée 21, la diode D7 est conductrice et la rampe d'allumage est seulement définie par la résistance R7A, l'inductance L1 et la capacité C9. Par contre, lors du front descendant de l'entrée 21, la diode D7 n'est plus conductrice et la rampe d'extinction est définie par les résistances R7A, R7B et R7C, les inductances L1 et L2 et la capacité C9. Cet agencement permet de donner une pente de la tension de référence moins importante pour l'extinction de l'IGBT que pour l'allumage. Les réglages des éléments R7A, R7B, R7C, C9, L1 et L2 dépendent des performances souhaitées et des caractéristiques de l'IGBT à commander. Un circuit d'amortissement, composé d'une diode D8 et d'une diode Zener ZD1, en parallèle avec la capacité C9 permet de limiter la tension de dépassement, ou overshoot, à une valeur par exemple proche de +16,5 V.

L'étage d'amplification en courant du dispositif de commande 10 fournit un courant de grille au composant IGBT à partir de la tension de référence du noeud 22. Il comprend un circuit d'amorçage 30 et un circuit d'extinction rapide 40 qui sont branchés tous les deux entre le noeud 22 et un noeud 23, lequel est directement connecté à la grille G de l'IGBT 11. Selon un mode de réalisation préféré, cet étage d'amplification est du type PUSH-PULL.

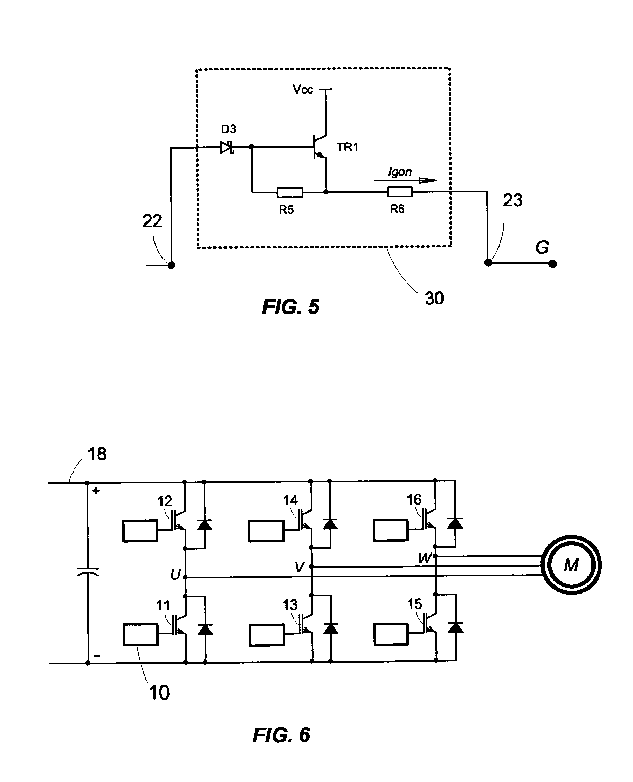

La figure 5 détaille le circuit d'amorçage 30 de l'étage d'amplification. Le circuit d'amorçage 30 est raccordé entre le noeud 22 et le noeud 23. Il comporte un transistor bipolaire TR1 de type NPN dont le collecteur est relié à la tension d'alimentation positive V_{cc} (sensiblement égale à +16V), dont l'émetteur est relié à une résistance d'amorçage R6 et dont la base est reliée à la cathode d'une diode D3. L'autre extrémité de la résistance d'amorçage R6 est reliée au noeud 23. L'anode de la diode D3 est reliée au noeud 22. La capacité Grille-Emetteur de l'IGBT 11 est chargée à travers la diode D3, le transistor TR1 et la résistance R6. La diode D3 est utilisée pour éviter le claquage de TR1 durant la phase d'extinction, quand la tension Base-Emetteur de TR1 peut être supérieure à 10V et peut faire augmenter les pertes de puissance dans TR1. La résistance d'amorçage R6 limite le courant de charge I_{gon} de la grille G et évite également l'oscillation parasite de la tension Grille-Emetteur provoquée par capacité Grille-Emetteur et l'inductance de fuite entre la borne de raccordement de grille sur l'IGBT et le dispositif de commande. La valeur minimale de la résistance d'amorçage R6 dépend de l'inductance de grille et de la capacité Grille-Emetteur à l'état OFF de l'IGBT.

Durant l'allumage de l'IGBT, la tension Collecteur-Emetteur V_{CE} commence à diminuer, de sorte que la tension Grille-Emetteur se maintient dans la zone dite du plateau de Miller. La tension issue du générateur de rampe 20 continue à augmenter selon la rampe d'allumage et le courant de charge de la grille commence à augmenter. Un fort courant de charge de la grille accélère la charge de la capacité Miller et réduit la tension résiduelle ainsi que les pertes de puissance à l'allumage. Cet effet dépend de la résistance de grille et de la rampe de la tension de grille de référence.

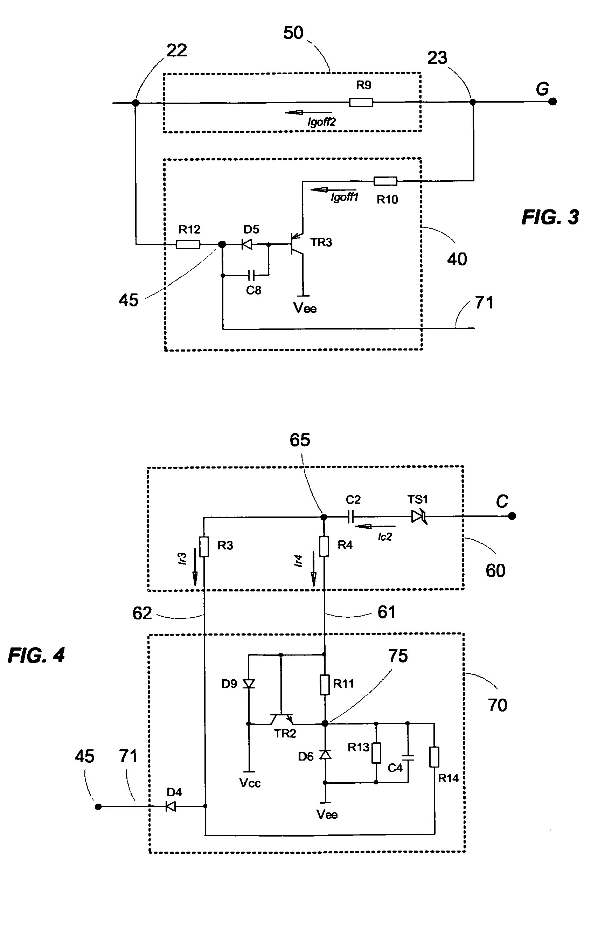

La figure 3 détaille le circuit d'extinction rapide 40 de l'étage d'amplification. Le circuit 40 est raccordé entre le noeud 22 et le noeud 23. Il comporte un transistor bipolaire principal TR3 de type PNP dont l'émetteur est relié au noeud 23 via une résistance d'extinction R10 et dont le collecteur est relié à la tension d'alimentation négative V_{EE} (sensiblement égale à -10V). La base de TR3 est raccordée à un noeud 45 à travers une diode D5 en parallèle avec une capacité C8. La capacité C8 permet d'accélérer le blocage du transistor TR3. Le noeud 45 est connecté au noeud 22 via une résistance R12 et est connecté à un signal de retour 71 provenant du circuit de retour 70.

Selon l'invention, le circuit de commande comprend également un circuit d'extinction lente 50 qui est raccordé directement entre le noeud 22 et le noeud 23 et qui comporte une résistance de décharge R9. La valeur de la résistance de décharge R9 est très supérieure à la résistance d'amorçage R6, de façon à ce que l'allumage du composant 11 se fasse prioritairement à travers le circuit d'amorçage 30. De plus, la valeur de R9 est très supérieure à la valeur de la résistance d'extinction R10, de façon à ce que, lorsque le transistor principal TR3 est passant, l'extinction du composant 11 se fasse prioritairement à travers le circuit d'extinction rapide 40.

La figure 4 détaille les circuits de détection 60 et de retour 70.

Le circuit de détection 60 a pour fonction de détecter rapidement une augmentation de la tension Collecteur-Emetteur V_{CE} de l'IGBT 11. Il comporte une diode Zener d'écrêtage TS1, de type Transcient Voltage Suppressor plus rapide qu'une diode Zener, dont la cathode est reliée au collecteur C de l'IGBT 11 et dont l'anode est reliée à un condensateur C2, l'autre extrémité du condensateur C2 étant reliée à un noeud 65. Quand la tension V_{CE} commence à augmenter, le condensateur C2 commence à se charger à travers la capacité de jonction de la diode TS1. Cette capacité de jonction de la diode TS1 dépend de la tension V_{CE} et de la variation de la tension V_{CE} dans le temps. Ces fonctions ne sont pas linéaires, en particulier au début de la phase d'extinction. Si on suppose que la tension de conduction inverse de la diode TS1 est très supérieure à la tension d'alimentation positive V_{cc}, alors la capacité de jonction de TS1 est largement inférieure à la capacité du condensateur C2 pour une tension de TS1 proche de la tension de conduction inverse. Quand la tension V_{CE} est supérieure à la tension de conduction inverse de TS1, la diode TS1 est conductrice et le condensateur C2 se charge avec un courant l_{c2}. Le courant l_{c2} du condensateur C2 se partage entre des courants Iᵣ₃ et Iᵣ₄, modulables en fonction des résistances R3 et R4 connectées au noeud 65, pour donner deux sorties, respectivement 62,61, du circuit de détection 60.

Le circuit de détection 60 permet ainsi simplement et rapidement de détecter un dépassement de seuil de la valeur de la tension V_{CE} (par exemple de l'ordre de 25% à 60% de la tension de bus continu) ainsi qu'un dépassement de seuil de la variation de la tension V_{CE} (par exemple de l'ordre de quelques kVolts par microseconde), de façon à générer rapidement les courants Iᵣ₃ et Iᵣ₄ sensiblement proportionnels à la variation de la tension V_{CE}. Ceci permet alors de contrôler efficacement la surtension de la tension Collecteur-Emetteur V_{CE} lors de la phase d'extinction. Les valeurs de ces seuils de dépassement dépendent de la technologie utilisée du composant IGBT.

Le circuit de retour 70, représenté en figure 4, reçoit la première sortie 61 (courant lᵣ₄) et la seconde sortie 62 (courant lᵣ₃) du circuit de détection 60 et est chargé de délivrer en sortie un signal de retour 71 qui est connecté au noeud 45 du circuit d'extinction rapide 40.

La seconde sortie 62 du circuit de détection 60, transportant le courant lᵣ₃ issu de R3, est directement connecté au signal de retour 71 à travers une diode D4. Le circuit de retour 70 comporte un transistor bipolaire auxiliaire TR2 de type NPN. Le collecteur du transistor auxiliaire TR2 est relié à la tension d'alimentation positive V_{cc}, la base de TR2 est reliée à la première sortie 61 transportant le courant Iᵣ₄ issu de R4, et l'émetteur de TR2 est relié à un noeud 75. Une diode D9 relie la base et le collecteur de TR2. Le noeud 75 est connecté au signal de retour 71 via la diode D4 et une résistance R14. Par ailleurs, une diode D6, une résistance R13 et un condensateur C4 sont branchés en parallèle entre le noeud 75 et la tension d'alimentation négative V_{EE} de façon à permettre la décharge de la capacité C2 lors d'un allumage du composant IGBT 11. Ainsi, la phase d'extinction du composant IGBT 11 comporte trois étapes :
1) Durant une première étape, le transistor principal TR3 est passant et le transistor auxiliaire TR2 est bloqué. La capacité Grille-Emetteur de l'IGBT 11 se décharge principalement à travers la résistance d'extinction R10 (car R10 est très inférieur à R9) et le transistor principal TR3, avec un fort courant de décharge I_{goff1} et un temps de plateau de Miller réduit. À la fin de la première étape, la tension Grille-Emetteur se trouve au-dessous du plateau de Miller, et le transistor MOSFET interne du composant IGBT 11 devient proche de l'état OFF. Dans ce cas, la majorité du courant de Collecteur est le courant du transistor BJT interne du composant 11. La valeur finale de la tension Grille-Emetteur dépend de la technologie du composant IGBT et peut être approximativement à zéro. Cette première étape va entraîner une augmentation de la tension V_{CE} qui va être détectée par le circuit de détection 60.
2) Une deuxième étape démarre lorsque le circuit de détection 60 détecte un dépassement de seuil de la tension V_{CE} du composant 11 (grâce à la diode TS1) et un dépassement de seuil de variation de la tension V_{CE} du composant 11 (grâce au condensateur C2) entraînant les courants lᵣ₃ et lᵣ₄. Ainsi, lors du dépassement de ces seuils, le circuit de retour 70 bloque rapidement le transistor principal TR3 au travers du signal de retour 71, via le courant lᵣ₃. En conséquence, la capacité Grille-Emetteur de l'IGBT 11 se décharge désormais uniquement à travers la résistance de décharge R9, avec un faible courant de décharge l_{goff2} inférieur à l_{goff1}. Par ailleurs, la majorité du courant lᵣ₄ va traverser la base du transistor TR2 qui va alors devenir passant.
   A ce stade, la tension Grille-Emetteur est au-dessous du plateau de Miller. Toutefois comme le transistor MOSFET interne est à l'état OFF et que la tension V_{CE} augmente rapidement, la capacité Grille-Emetteur se charge par un courant additionnel (plus fort que le courant de décharge) par la capacité Miller de l'IGBT 11. Ainsi la tension Grille-Emetteur revient au-dessus du plateau de Miller, donc le transistor MOSFET repasse à l'état ON de sorte que le courant de Collecteur peut de nouveau être commandé. La capacité Grille-Emetteur est rechargée par la capacité Miller.
   Tant que le transistor auxiliaire TR2 était bloqué lors de la première étape, la tension au noeud 75 était approximativement équivalente à la tension d'alimentation V_{EE} et la diode D9 est non-conductrice. Durant la seconde étape, le transistor TR2 devient passant, ce qui entraîne une augmentation de la tension au noeud 75 vers une valeur proche de la tension d'alimentation positive V_{CC}. La diode D9 devient passante, ce qui sature profondément le transistor TR2 et un courant circule dans le signal de retour 71 via la résistance R14 et la diode D4, au bout du temps nécessaire au chargement de la capacité C4. Grâce à ce montage, le transistor TR2 va pouvoir être maintenu passant durant un temps de maintien déterminé (ou temps de stockage) après l'annulation de la première sortie 61.
   Simultanément, le courant lᵣ₃ traverse la diode D4 et la tension au noeud 45 commence immédiatement à augmenter. Au noeud 45, le courant venant du signal de retour 71 se sépare entre un courant de rétroaction traversant la résistance R12 pour agir sur la tension de référence au noeud 22 et un courant de chargement du condensateur C8, permettant de bloquer le transistor principal TR3. La tension au noeud 45 est approximativement équivalente à la tension d'alimentation positive V_{CC} et maintient la diode D5 et le transistor TR3 à l'état bloqué.
   Le transistor MOSFET interne de l'IGBT est alors proche de l'état OFF. La valeur et la pente de la tension V_{CE} de l'IGBT sont alors définies par la caractéristique dynamique du transistor BJT interne de l'IGBT. Une augmentation rapide de la tension V_{CE} génère un signal de retour 71 qui éteint le transistor principal TR3 et réinjecte du courant dans la capacité de grille via la capacité Miller, de sorte que la tension Grille-Emetteur commence à augmenter jusqu'au plateau de Miller et remet le transistor MOSFET interne à l'état ON. L'IGBT revient dans sa plage de fonctionnement linéaire, si bien que la rampe de la tension Grille-Emetteur peut de nouveau contrôler la pente du courant de Collecteur.
   Avantageusement, lorsque le transistor principal TR3 est bloqué, la capacité Grille-Emetteur continue de se décharger avec un faible courant I_{goff2} grâce à la résistance de décharge R9 du circuit d'extinction lente 50 et en suivant la rampe d'extinction de la tension de référence issue du circuit 20.
   Durant la deuxième étape, la tension V_{CE} de l'IGBT cesse d'augmenter et la variation de tension V_{CE} repasse sous son seuil de dépassement, ce qui annule les sorties 61,62. Néanmoins, cette deuxième étape se prolonge car le transistor auxiliaire TR2 reste passant pendant le temps de maintien dû à la saturation (c'est-à-dire la période de temps s'écoulant entre le passage à zéro de la base de TR2 et le début de l'augmentation du courant dans le collecteur de TR2), c'est-à-dire une durée de l'ordre de 0,5 à 1 microseconde environ.
   Durant ce temps de maintien déterminé, le transistor principal TR3 est avantageusement maintenu à l'état bloqué par le signal de retour 71. Ce temps de maintien est important car le transistor principal TR3 doit rester bloqué suffisamment longtemps pour que l'IGBT s'éteigne complètement, dans toutes les conditions. A la fin de ce temps de maintien, le transistor auxiliaire TR2 repasse à l'état bloqué, et la tension au noeud 75 diminue progressivement jusqu'à la tension d'alimentation négative V_{EE}. La diode D4 se bloque et le transistor principal TR3 revient à l'état passant ce qui déclenche la troisième étape.
3) Une troisième étape finale permet de terminer rapidement la décharge de la capacité Grille-Emetteur de l'IGBT 11, ayant pour résultat de raccourcir la durée totale de la phase d'extinction de l'IGBT. Durant cette étape, la capacité Grille-Emetteur se décharge avec un fort courant à travers la résistance d'extinction R10, puisque le transistor principal TR3 est de nouveau passant. Ceci permet alors de terminer rapidement la phase d'extinction.
   Le courant de Collecteur diminue ainsi avec la pente définie par la rampe de la tension de référence et la transconductance dynamique gₘ. La tension V_{CE} reste à une valeur crête, défini par la pente du courant de Collecteur et l'inductance de commutation totale. Lorsque le courant de Collecteur atteint le courant résiduel (ou courant de queue), la tension V_{CE} diminue jusqu'à approximativement la tension de bus continu.
   Le condensateur C2 sera déchargé par les résistances R11, R4 et la diode D6 du circuit 70 durant la prochaine phase d'allumage du composant IGBT, quand la tension V_{CE} commencera à diminuer.

La figure 6 montre un exemple d'utilisation de l'invention dans un appareil de commande d'un moteur électrique M asynchrone triphasé, de type convertisseur de fréquence. L'appareil de commande comporte deux composants pour la commande de chaque phase U,V,WW du moteur M, à savoir six composants de puissance 11,12,13,14,15,16 dans l'exemple d'un moteur triphasé. Les composants 11,12,13,14,15,16 sont chargés de fournir une tension d'amplitude et de fréquence variable au moteur à partir d'une tension de bus continu 18, permettant ainsi au moteur de fournir une vitesse variable. Chaque composant de puissance IGBT est commandé à partir d'un dispositif de commande 10 conforme à la présente invention.

Il est bien entendu que l'on peut, sans sortir du cadre de l'invention, imaginer d'autres variantes et perfectionnements de détail et de même envisager l'emploi de moyens équivalents.

## Revendications

1. Dispositif de commande de grille (10) d'un composant semi-conducteur de puissance (11) de type IGBT, comprenant :
- Un circuit d'entrée (20) fournissant en sortie (22) une tension de grille de référence à partir d'un ordre de commande (21) du composant IGBT (11),
- Un étage d'amplification en courant de ladite tension de référence pour délivrer un courant de grille du composant IGBT (11), cet étage d'amplification comprenant un circuit d'amorçage (30) et un circuit d'extinction rapide (40),
- Un circuit d'extinction lente (50) connecté entre la grille (G) du composant IGBT (11) et la sortie (22) du circuit d'entrée (20),
- Un circuit de détection (60) d'une tension Collecteur-Emetteur du composant IGBT (11),
**caractérisé en ce que** le circuit d'entrée est un circuit générateur de rampe (20) et **en ce que** le dispositif comporte un circuit de retour (70) connecté en sortie du circuit de détection (60) et fournissant un signal de retour (71) agissant sur le circuit d'extinction rapide (40) et sur la sortie (22) du circuit générateur (20).

2. Dispositif de commande selon la revendication 1, **caractérisé en ce que** le circuit générateur de rampe (20) établit une tension de référence selon une rampe de montée suite à un ordre de commande d'allumage du composant IGBT (11) et selon une rampe de descente, différente de la rampe de montée, suite à un ordre de commande d'extinction du composant IGBT (11).

3. Dispositif de commande selon la revendication 1, **caractérisé en ce que** le circuit de détection (60) détecte un dépassement de seuil de la tension Collecteur-Emetteur du composant IGBT (11) et un dépassement de seuil de variation de la tension Collecteur-Emetteur du composant IGBT (11).

4. Dispositif de commande selon la revendication 1, **caractérisé en ce que** le circuit d'extinction rapide (40) comporte un transistor bipolaire principal (TR3) dont la base est pilotée par la sortie du circuit générateur (20) et par le signal de retour (71), et dont l'émetteur est relié à la grille du composant IGBT (11) via une résistance d'extinction (R10).

5. Dispositif de commande selon la revendication 4, **caractérisé en ce que** le circuit d'extinction lente (50) comporte une résistance de décharge (R9) supérieure à la résistance d'extinction (R10).

6. Dispositif de commande selon la revendication 1, **caractérisé en ce que** l'étage d'amplification est du type PUSH-PULL.

7. Dispositif de commande selon la revendication 1, **caractérisé en ce que** le circuit de retour (70) comporte un transistor bipolaire auxiliaire (TR2) dont la base est reliée à une première sortie (61) du circuit de détection (60), dont le collecteur est relié à une tension d'alimentation positive et dont l'émetteur est relié au signal de retour (71), de façon à maintenir le signal de retour (71) durant un temps de maintien déterminé.

8. Dispositif de commande selon la revendication 7, **caractérisé en ce qu'**une seconde sortie (62) du circuit de détection (60) est directement reliée au signal de retour (71).

9. Appareil de commande d'un moteur (M) comprenant deux composants de puissance de type IGBT pour chaque phase (U,V,W) dudit moteur, **caractérisé en ce que** chaque composant de puissance (11,12,13,14,15,16) de l'appareil est commandé par un dispositif de commande (10) selon l'une des revendications précédentes.

10. Méthode de commande pour l'extinction d'un composant semi-conducteur de puissance (11) de type IGBT, la méthode comportant :
- Une première étape durant laquelle la capacité Grille-Emetteur du composant IGBT (11) se décharge principalement à travers une résistance d'extinction (R10) d'un circuit d'extinction rapide (40),
- Une deuxième étape durant laquelle un circuit de retour (70), connecté en sortie d'un circuit de détection (60) d'une tension Collecteur-Emetteur du composant IGBT (11), fournit un signal de retour (71) agissant sur le circuit d'extinction rapide (40), pour que la capacité Grille-Emetteur se décharge durant un temps de maintien uniquement à travers une résistance de décharge (R9) supérieure à la résistance d'extinction (R10),
- Une troisième étape durant laquelle la capacité Grille-Emetteur se décharge principalement à travers la résistance d'extinction (R10).

## Claims

1. Gate control device (10) of a power semiconductor component (11) of the IGBT type, comprising:
- an input circuit (20) delivering at its output (22) a reference gate voltage from a control command (21) of the IGBT component (11);
- a stage for the current amplification of the said reference voltage in order to deliver a gate current to the IGBT component (11), this amplification stage comprising an ignition circuit (30) and a rapid extinction circuit (40);
- a slow extinction circuit (50) connected between the gate (G) of the IGBT component (11) and the output (22) of the input circuit (20); and
- a circuit (60) for the detection of a collector-emitter voltage of the IGBT component (11),
**characterized in that** the input circuit is a ramp generator circuit (20) and **in that** the device comprises a feedback circuit (70) connected to the output of the detection circuit (60) and delivering a feedback signal (71) that acts on the rapid extinction circuit (40) and on the output (22) of the generator circuit (20).

2. Control device according to Claim 1, **characterized in that** the ramp generator circuit (20) establishes a reference voltage according to a rising ramp following an ignition control command for the IGBT component (11) and according to a falling ramp, different from the rising ramp, following an extinction control command for the IGBT component (11).

3. Control device according to Claim 1, **characterized in that** the detection circuit (60) detects a threshold overshoot of the collector-emitter voltage of the IGBT component (11) and a threshold overshoot of the variation in the collector-emitter voltage of the IGBT component (11).

4. Control device according to Claim 1, **characterized in that** the rapid extinction circuit (40) comprises a main bipolar transistor (TR3) whose base is driven by the output of the generator circuit (20) and by the feedback signal (71), and whose emitter is connected to the gate of the IGBT component (11) via an extinction resistor (R10).

5. Control device according to Claim 4, **characterized in that** the slow extinction circuit (50) comprises a discharge resistor (R9) whose resistance is greater than the extinction resistor (R10).

6. Control device according to Claim 1, **characterized in that** the amplification stage is of the PUSH-PULL type.

7. Control device according to Claim 1, **characterized in that** the feedback circuit (70) comprises an auxiliary bipolar transistor (TR2) whose base is connected to a first output (61) of the detection circuit (60), whose collector is connected to a positive power supply voltage and whose emitter is connected to the feedback signal (71), so as to hold the feedback signal (71) for a defined hold time.

8. Control device according to Claim 7, **characterized in that** a second output (62) of the detection circuit (60) is directly connected to the feedback signal (71).

9. Control apparatus for a motor (M) comprising two power components of the IGBT type for each phase (U,V,W) of the said motor, **characterized in that** each power component (11,12,13,14,15,16) of the apparatus is controlled by a control device (10) according to one of the preceding claims.

10. Control method for controlling the extinction of a power semiconductor component (11) of the IGBT type, the method comprising:
- a first step during which the gate-emitter capacitance of the IGBT component (11) discharges mainly through an extinction resistor (R10) of a rapid extinction circuit (40);
- a second step during which a feedback circuit (70) connected to the output of a circuit (60) for the detection of a collector-emitter voltage of the IGBT component (11) delivers a feedback signal (71) acting on the rapid extinction circuit (40), so that the gate-emitter capacitance discharges for a hold time only through a discharge resistor (R9) whose resistance is greater than the extinction resistor (R10); and a third step during which the gate-emitter capacitance discharges mainly through the extinction resistor (R10) .

## Patentansprüche

1. Gate-Steuervorrichtung (10) eines Leistungshalbleiter-Bauteils (11) vom Typ IGBT, die enthält:
- eine Eingangsschaltung (20), die am Ausgang (22) eine Referenz-Gatespannung ausgehend von einem Steuerbefehl (21) des IGBT-Bauteils (11) liefert,
- eine Stromverstärkungsstufe der Referenzspannung, um einen Gatestrom des IGBT-Bauteils (11) zu liefern, wobei diese Verstärkungsstufe eine Zündschaltung (30) und eine schnelle Löschschaltung (40) enthält,
- eine langsame Löschschaltung (50), die zwischen das Gate (G) des Bauteils (11) und den Ausgang (22) der Eingangsschaltung (20) geschaltet ist,
- eine Schaltung (60) zur Erfassung einer Kollektor-Emitter-Spannung des IGBT-Bauteils (11),
**dadurch gekennzeichnet, dass** die Eingangsschaltung eine Rampengeneratorschaltung (20) ist, und dass die Vorrichtung eine Rückkopplungsschaltung (70) aufweist, die mit dem Ausgang der Erfassungsschaltung (60) verbunden ist und ein Rückkopplungssignal (71) liefert, das auf die schnelle Löschschaltung (40) und auf den Ausgang (22) der Generatorschaltung (20) einwirkt.

2. Steuervorrichtung nach Anspruch 1, **dadurch gekennzeichnet, dass** die Rampengeneratorschaltung (20) eine Referenzspannung gemäß einer Anstiegsrampe nach einem Zündsteuerbefehl des IGBT-Bauteils (11), und gemäß einer Abstiegsrampe, die sich von der Anstiegsrampe unterscheidet, nach einem Löschsteuerbefehl des IGBT-Bauteils (11) aufbaut.

3. Steuervorrichtung nach Anspruch 1, **dadurch gekennzeichnet, dass** die Erfassungsschaltung (60) eine Schwellenüberschreitung der Kollektor-Emitter-Spannung des IGBT-Bauteils (11) und eine Schwellenüberschreitung der Änderung der Kollektor-Emitter-Spannung des IGBT-Bauteils (11) erfasst.

4. Steuervorrichtung nach Anspruch 1, **dadurch gekennzeichnet, dass** die schnelle Löschschaltung (40) einen bipolaren Haupttransistor (TR3) aufweist, dessen Basis vom Ausgang der Generatorschaltung (20) und vom Rückkopplungssignal (71) gesteuert wird, und dessen Emitter über einen Löschwiderstand (R10) mit dem Gate des IGBT-Bauteils (11) verbunden ist.

5. Steuervorrichtung nach Anspruch 4, **dadurch gekennzeichnet, dass** die langsame Löschschaltung (50) einen Entladewiderstand (R9) aufweist, der höher ist als der Löschwiderstand (R10).

6. Steuervorrichtung nach Anspruch 1, **dadurch gekennzeichnet, dass** die Verstärkungsstufe vom Typ PUSH-PULL ist.

7. Steuervorrichtung nach Anspruch 1, **dadurch gekennzeichnet, dass** die Rückkopplungsschaltung (70) einen bipolaren Hilfstransistor (TR2) aufweist, dessen Basis mit einem ersten Ausgang (61) der Erfassungsschaltung (60) verbunden ist, dessen Kollektor mit einer positiven Speisespannung verbunden ist, und dessen Emitter mit dem Rückkopplungssignal (71) verbunden ist, um das Rückkopplungssignal (71) während einer bestimmten Haltezeit aufrechtzuerhalten.

8. Steuervorrichtung nach Anspruch 7, **dadurch gekennzeichnet, dass** ein zweiter Ausgang (62) der Erfassungsschaltung (60) direkt mit dem Rückkopplungssignal (71) verbunden ist.

9. Gerät zur Steuerung eines Motors (M), das zwei Leistungsbauteile vom Typ IGBT für jede Phase (U,V,W) des Motors aufweist, **dadurch gekennzeichnet, dass** jedes Leistungsbauteil (11, 12, 13, 14, 15, 16) des Geräts von einer Steuervorrichtung (10) nach einem der vorhergehenden Ansprüche gesteuert wird.

10. Steuerverfahren zum Löschen eines Leistungshalbleiterbauteils (11) vom Typ IGBT, wobei das Verfahren enthält:
- einen ersten Schritt, während dem die Gate-Emitter-Kapazität des IGBT-Bauteils (11) sich hauptsächlich über einen Löschwiderstand (R10) einer schnellen Löschschaltung (40) entlädt,
- einen zweiten Schritt, während dem eine Rückkopplungsschaltung (70), die mit dem Ausgang einer Erfassungsschaltung (60) einer Kollektor-Emitter-Spannung des IGBT-Bauteils (11) verbunden ist, ein Rückkopplungssignal (71) liefert, das auf die schnelle Löschschaltung (40) einwirkt, damit die Gate-Emitter-Kapazität sich während einer Haltezeit nur über einen Entladewiderstand (R9) höher als der Löschwiderstand (R10) entlädt,
- einen dritten Schritt, während dem die Gate-Emitter-Kapazität sich hauptsächlich über den Löschwiderstand (R10) entlädt.
